# EUROPEAN PATENT SPECIFICATION

(11) **EP 4 156 508 B1**
(45) Date of publication and mention of the grant of the patent: **21.08.2024**
(21) Application number: 20941985.2
(22) Date of filing: 24.06.2020
(51) Int. Cl.: H03F 1/42, H03F 1/02, H03F 1/56, H03F 3/60

(54) **DOHERTY AMPLIFIER**
DOHERTY-VERSTÄRKER
AMPLIFICATEUR DE DOHERTY

(43) Date of publication of application: 29.03.2023
(73) Proprietor: MITSUBISHI ELECTRIC CORPORATION, Chiyoda-ku Tokyo 100-8310 (JP)
(72) Inventor: NAKATANI, Keigo, Tokyo 100-8310 (JP); KOMATSUZAKI, Yuji, Tokyo 100-8310 (JP); SHINJO, Shintaro, Tokyo 100-8310 (JP)
(74) Representative: Pfenning, Meinig & Partner mbB
(86) International application number: PCT/JP2020/024778
(87) International publication number: WO 2021/260828

(56) References cited:
- EP-A1- 3 648 343
- WO-A1-2014/108716
- JP-A- 2013 090 037
- JP-A- 2015 207 941
- US-A1- 2012 075 018
- US-A1- 2016 164 474
- US-A1- 2018 367 104

## Description

### TECHNICAL FIELD

The present disclosure relates to a Doherty amplifier.

### BACKGROUND ART

Among Doherty amplifiers used as amplifiers for wireless communications, there are Doherty amplifiers in each of which two carrier amplifiers are connected in series and two peak amplifiers are connected in series.

By the way, in a typical Doherty amplifier including a splitter circuit, a carrier amplifier, a peak amplifier and a combiner, a loop in which one of two signals into which a signal is split by the splitter circuit passes through each of the following circuits: the carrier amplifier, the combiner and the peak amplifier, and then returns to the splitter circuit may be formed. In order to suppress a loop oscillation which occurs because such a loop has a gain, there is a Doherty amplifier in which a splitter circuit includes a low pass filter which is a π type circuit and a high pass filter which is a T type circuit (for example, refer to Patent Literature 1).

Document US 2018/367104 A1 describes interstage matching networks which mitigate nonlinear effects associated with high performance semiconductor technologies.

Document US 2012/075018 A1 describes a power amplifier.

Document US 2016/164474 A1 describes linear and efficient broadband power amplifiers.

Document EP 3 648 343 A1 describes a Doherty amplifier and an amplification circuit for amplifying a signal to be amplified.

### CITATION LIST

### PATENT LITERATURE

Patent Literature 1: WO 2017/119062

### SUMMARY OF INVENTION

### TECHNICAL PROBLEM

In conventional Doherty amplifiers in each of which two carrier amplifiers are connected in series and two peak amplifiers are connected in series, at a time of backoff operations of the peak amplifiers, a signal amplified by the two carrier amplifiers may pass through the peak amplifier on an output side, out of the two peak amplifiers, as a return signal. At this time, there is a problem that an oscillation phenomenon occurs in which the return signal which has passed through the peak amplifier on the output side is reflected by the other peak amplifier on an input side, and in which the return signal reflected by the other peak amplifier on the input side is further reflected by the peak amplifier on the output side.

Even though the splitter circuit in the Doherty amplifier described in Patent Literature 1 can prevent loop oscillations, the splitter circuit cannot be used to solve the above-mentioned problem.

### SOLUTION TO PROBLEM

The invention is set out in the appended set of claims.

### ADVANTAGEOUS EFFECTS OF INVENTION

According to the present disclosure, an oscillation phenomenon occurring between the first auxiliary amplification element and the second auxiliary amplification element can be prevented.

### BRIEF DESCRIPTION OF DRAWINGS

Fig. 1 is a schematic diagram showing a Doherty amplifier according to Embodiment 1;
Fig. 2 is a schematic diagram showing an example of a first phase adjustment circuit 13;
Fig. 3 is a schematic diagram showing an example of the first phase adjustment circuit 13;
Fig. 4 is an explanatory drawing showing a result of simulation of a stability factor at a time of a backoff operation of the Doherty amplifier;
Fig. 5 is a schematic diagram showing a Doherty amplifier according to Embodiment 2; and
Fig. 6 is a schematic diagram showing a Doherty amplifier according to Embodiment 3.

### DESCRIPTION OF EMBODIMENTS

Hereinafter, in order to explain the present disclosure in greater detail, embodiments of the present disclosure will be explained with reference to the accompanying drawings.

### Embodiment 1.

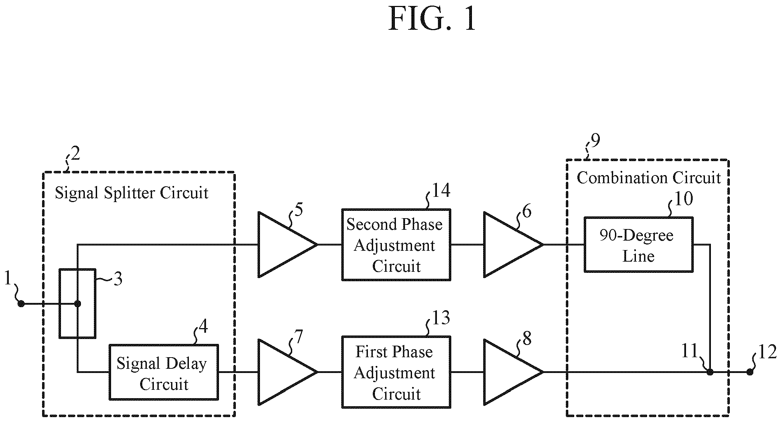

Fig. 1 is a schematic diagram showing a Doherty amplifier according to Embodiment 1.

In Fig. 1, an input terminal 1 is one to which a signal to be amplified is supplied from the outside.

A signal splitter circuit 2 includes a T-branch circuit 3 and a signal delay circuit 4.

The signal splitter circuit 2 splits the signal to be amplified into two signals, and outputs one of the signals after split, as a first signal, to a first main amplification element 5.

The signal splitter circuit 2 delays the phase of the other one of the signals after split by 90 degrees, and outputs the other signal whose phase is delayed by 90 degrees, as a second signal, to a first auxiliary amplification element 7.

The T-branch circuit 3 splits the signal to be amplified into two signals, and outputs one of the signals after split, as a first signal, to the first main amplification element 5 and outputs the other one of the signals after split to the signal delay circuit 4.

The signal delay circuit 4 delays the phase of the other signal outputted from the T-branch circuit 3 by 90 degrees, and outputs the other signal whose phase is delayed by 90 degrees, as a second signal, to the first auxiliary amplification element 7.

In the Doherty amplifier shown in Fig. 1, the signal splitter circuit 2 includes the T-branch circuit 3 and the signal delay circuit 4. However, this is only an example, and the signal splitter circuit 2 may include a Wilkinson power splitter circuit instead of the T-branch circuit 3, or may include a 90-degree hybrid circuit instead of the T-branch circuit 3 and the signal delay circuit 4.

In the Doherty amplifier shown in Fig. 1, it is assumed that the one of the signals after split by the T-branch circuit 3 and the other one of the signals after split by the T-branch circuit 3 have the same amplitude. However, this is only an example, and the one of the signals after split by the T-branch circuit 3 and the other one of the signals after split by the T-branch circuit 3 may have different amplitudes.

Note that, to the input terminal 1, a circuit such as an impedance conversion circuit or a phase circuit may be connected.

The first main amplification element 5 is implemented by, for example, either a field effect transistor (FET) or an amplification circuit including an FET and an impedance conversion circuit.

The first main amplification element 5 is a carrier amplifier that operates in AB class, and amplifies the first signal outputted from the signal splitter circuit 2 and outputs the amplified first signal to a second main amplification element 6 via a second phase adjustment circuit 14.

The second main amplification element 6 is implemented by, for example, either an FET or an amplification circuit including an FET and an impedance conversion circuit.

The second main amplification element 6 is a carrier amplifier that operates in AB class, and further amplifies the first signal amplified by the first main amplification element 5 and outputs the amplified first signal to a combination circuit 9.

The first auxiliary amplification element 7 is implemented by, for example, either an FET or an amplification circuit including an FET and an impedance conversion circuit.

The first auxiliary amplification element 7 is a peak amplifier that operates in either B class or C class at a time of a backoff operation, and that operates in AB class at a time of a saturated operation.

The first auxiliary amplification element 7 amplifies the second signal outputted from the signal splitter circuit 2, and outputs the amplified second signal to a second auxiliary amplification element 8 via a first phase adjustment circuit 13.

The time of the backoff operation is an operation when because the power of the second signal outputted from the signal splitter circuit 2 is small, the output power of the first auxiliary amplification element 7 is lower than the output power of the first main amplification element 5. The time of the saturated operation is an operation when the output power of the first auxiliary amplification element 7 is the same as the output power of the first main amplification element 5.

The second auxiliary amplification element 8 is implemented by, for example, either an FET or an amplification circuit including an FET and an impedance conversion circuit.

The second auxiliary amplification element 8 is a peak amplifier that operates in either B class or C class at a time of a backoff operation, and that operates in AB class at a time of a saturated operation.

The second auxiliary amplification element 8 further amplifies the second signal amplified by the first auxiliary amplification element 7, and outputs the amplified second signal to the combination circuit 9.

The time of the backoff operation is an operation when because the power of the second signal amplified by the first auxiliary amplification element 7 is small, the output power of the second auxiliary amplification element 8 is lower than the output power of the second main amplification element 6.

The time of the saturated operation is an operation when the output power of the second auxiliary amplification element 8 is the same as the output power of the second main amplification element 6.

The combination circuit 9 includes a 90-degree line 10 and a signal combination point 11.

The combination circuit 9 combines the first signal amplified by the second main amplification element 6 and the second signal amplified by the second auxiliary amplification element 8, and outputs a composite signal of the first signal and the second signal to an output terminal 12.

The 90-degree line 10 is a circuit having an electric length of 90 degrees in the operating frequency band of the signal to be amplified.

At the signal combination point 11, the first signal which has passed through the 90-degree line 10 and the second signal amplified by the second auxiliary amplification element 8 are combined.

In the Doherty amplifier shown in Fig. 1, the combination circuit 9 includes the 90-degree line 10 and the signal combination point 11. What is necessary for the combination circuit 9 is just to be able to combine the first signal amplified by the second main amplification element 6 and the second signal amplified by the second auxiliary amplification element 8, and the combination circuit 9 may be implemented by, for example, a lumped constant element, a distributed constant element, a π type circuit, a T type circuit, or a combination of those elements or circuits.

The output terminal 12 is a terminal via which the composite signal outputted from the combination circuit 9 is outputted to the outside.

Note that, to the output terminal 12, a circuit such as an impedance conversion circuit or a phase circuit may be connected.

The first phase adjustment circuit 13 is implemented by, for example, a lumped constant element, a distributed constant element, a π type circuit, a T type circuit, or a combination of those elements or circuits.

One end of the first phase adjustment circuit 13 is connected to an output side of the first auxiliary amplification element 7, and the other end of the first phase adjustment circuit 13 is connected to an input side of the second auxiliary amplification element 8.

At the time of the backoff operation of the second auxiliary amplification element 8, there is a case in which the first signal amplified by the second main amplification element 6 passes through the second auxiliary amplification element 8 as a return signal, and, as a result, the return signal goes to the first auxiliary amplification element 7. Further, there is a case in which the return signal is reflected by the first auxiliary amplification element 7, and, as a result, the return signal goes to the second auxiliary amplification element 8.

The first phase adjustment circuit 13 adjusts either the phase of the return signal going to the first auxiliary amplification element 7 or the phase of the return signal going to the second auxiliary amplification element 8 in such a way that the sum of the phase of the return signal going to the first auxiliary amplification element 7 and the phase of the return signal going to the second auxiliary amplification element 8 is not equal to 0 degrees in the operating frequency band of the first signal.

The first phase adjustment circuit 13 acts as an impedance converter at the time of the saturated operation of the second auxiliary amplification element 8.

The second phase adjustment circuit 14 is implemented by, for example, a lumped constant element, a distributed constant element, a π type circuit, a T type circuit, or a combination of those elements or circuits.

One end of the second phase adjustment circuit 14 is connected to an output side of the first main amplification element 5, and the other end of the second phase adjustment circuit 14 is connected to an input side of the second main amplification element 6.

The second phase adjustment circuit 14 adjusts the phase of the first signal going from the first main amplification element 5 to the second main amplification element 6 in order to make the signal which reaches the signal combination point 11 via the first main amplification element 5 from the T-branch circuit 3 be in phase with the signal which reaches the signal combination point 11 via the first auxiliary amplification element 7 from the T-branch circuit 3.

Next, the operation of the Doherty amplifier shown in Fig. 1 will be explained.

If the second auxiliary amplification element 8 which is a peak amplifier is an ideal transistor, the impedance of the second auxiliary amplification element is high at the time of the backoff operation. Therefore, the connection of the second auxiliary amplification element 8 to the signal combination point 11 of the combination circuit 9 is equivalently in a connectionless state. More specifically, an output side of the second auxiliary amplification element 8 serves as an open end equivalently.

However, because the second auxiliary amplification element 8 mounted in the Doherty amplifier shown in Fig. 1 has an isolation characteristic, there is a case in which the impedance of the second auxiliary amplification element 8 is not high depending on the frequency f₀ of the signal to be amplified.

In the case where the impedance of the second auxiliary amplification element 8 is not high at the time of the backoff operation of the second auxiliary amplification element 8, the first signal amplified by the second main amplification element 6 may pass through the second auxiliary amplification element 8 as a return signal.

At this time, there may occur an oscillation phenomenon in which the return signal which has passed through the second auxiliary amplification element 8 is reflected by the first auxiliary amplification element 7, and the return signal reflected by the first auxiliary amplification element 7 is further reflected by the second auxiliary amplification element 8.

In accordance with the Nyquist theorem, at the frequency where the sum of the phase of the return signal going to the first auxiliary amplification element 7 and the phase of the return signal going to the second auxiliary amplification element 8 is 0 degrees, the return signal has the maximum gain. When the return signal has the maximum gain, the above-mentioned oscillation phenomenon is maximized.

In order to prevent the above-mentioned oscillation phenomenon, the first phase adjustment circuit 13 adjusts either the phase of the return signal going to the first auxiliary amplification element 7 or the phase of the return signal going to the second auxiliary amplification element 8 in such a way that the sum of the phase of the return signal going to the first auxiliary amplification element 7 and the phase of the return signal going to the second auxiliary amplification element 8 is not equal to 0 degrees at the frequency f₀ of the signal to be amplified.

It is assumed that the phase of the return signal going to the second auxiliary amplification element 8 is, for example, within a range of +45 degrees to +65 degrees in the operating frequency band of the signal to be amplified. In this case, the first phase adjustment circuit 13 adjusts the phase of the return signal going to the first auxiliary amplification element 7 in such a way that the phase of the return signal going to the first auxiliary amplification element 7 does not fall within a range of -45 degrees to -65 degrees.

In the Doherty amplifier shown in Fig. 1, the first phase adjustment circuit 13 adjusting either the phase of the return signal going to the first auxiliary amplification element 7 or the phase of the return signal going to the second auxiliary amplification element 8 in such a way that the sum of the phase of the return signal going to the first auxiliary amplification element 7 and the phase of the return signal going to the second auxiliary amplification element 8 is not equal to 0 degrees. What is necessary is just to make the sum of the phase of the return signal going to the first auxiliary amplification element 7 and the phase of the return signal going to the second auxiliary amplification element 8 be not 0 degrees. Therefore, the first phase adjustment circuit 13 may adjust either the phase of the return signal going to the first auxiliary amplification element 7 or the phase of the return signal going to the second auxiliary amplification element 8 in such a way that the sum does not fall within a range of -5 degrees to +5 degrees, for example.

In the Doherty amplifier shown in Fig. 1, the first phase adjustment circuit 13 has a characteristic impedance of the same value as the output impedance of the first auxiliary amplification element 7 at the time of the saturated operation or the input impedance of the second auxiliary amplification element 8 at the time of the saturated operation.

Because the first phase adjustment circuit 13 has the above-mentioned characteristic impedance, the first phase adjustment circuit can change only the phase characteristic at the time of the backoff operation without having an influence on the impedance matching at the time of the saturated operation.

It is assumed that the input impedance of the second auxiliary amplification element 8 at the time of the saturated operation is, for example, 50 Ω, and the phase of the return signal going to the second auxiliary amplification element 8 is within a range of +45 degrees to +65 degrees, for example. In this case, the first phase adjustment circuit 13 has a circuit configuration in which the first phase adjustment circuit has a characteristic impedance of 50 Ω and has a phase characteristic where the phase of the return signal going to the first auxiliary amplification element 7 is outside a range of -45 degrees to -65 degrees.

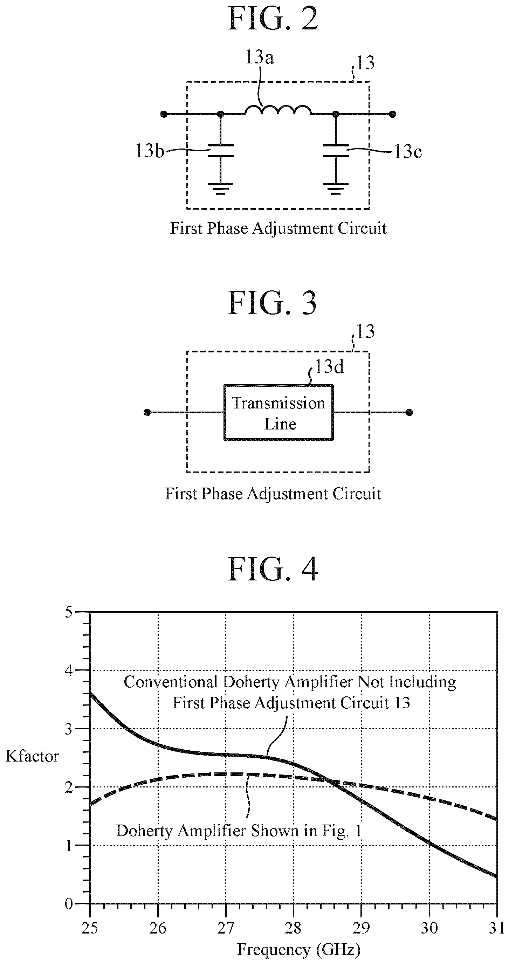

Each of Figs. 2 and 3 is a schematic diagram showing an example of the first phase adjustment circuit 13.

The circuit configuration of the first phase adjustment circuit 13 is determined on the basis of the operating frequency band of the signal to be amplified.

The first phase adjustment circuit 13 shown in Fig. 2 is implemented by a coil 13a and capacitors 13b and 13c.

One end of the coil 13a is connected to the output side of the first auxiliary amplification element 7, and the other end of the coil 13a is connected to the input side of the second auxiliary amplification element 8.

One end of the capacitor 13b is connected to each of the following parts: the output side of the first auxiliary amplification element 7 and the one end of the coil 13a, and the other end of the capacitor 13b is grounded.

One end of the capacitor 13c is connected to each of the following parts: the input side of the second auxiliary amplification element 8 and the other end of the coil 13a, and the other end of the capacitor 13c is grounded.

The first phase adjustment circuit 13 shown in Fig. 3 is implemented by a transmission line 13d.

The configuration of the first phase adjustment circuit 13 shown by each of Figs. 2 and 3 is only an example, and the first phase adjustment circuit 13 may have a configuration different from that shown by each of Figs. 2 and 3 as long as the first phase adjustment circuit can change the phase characteristic at the time of the backoff operation while implementing the impedance matching at the time of the saturated operation.

Fig. 4 is an explanatory drawing showing a result of simulation of a stability factor at the time of the backoff operation of the Doherty amplifier.

In Fig. 4, a solid line shows the stability factor (Kfactor) at the time of the backoff operation of a conventional Doherty amplifier which does not include the first phase adjustment circuit 13. A broken line shows the stability factor at the time of the backoff operation of the Doherty amplifier shown in Fig. 1.

The operating frequency band of the signal to be amplified ranges from 25 to 31 GHz.

In the conventional Doherty amplifier, the stability factor is equal to or less than 1 and thus its amplifying operation is unstable, depending on the operating frequency of the signal to be amplified.

In the Doherty amplifier shown in Fig. 1, the stability factor is equal to or greater than 1 and thus its amplifying operation is stable over the entire operating frequency band.

In above-mentioned Embodiment 1, the Doherty amplifier includes: the first main amplification element 5 to amplify the first signal; the second main amplification element 6 to amplify the first signal amplified by the first main amplification element 5; the first auxiliary amplification element 7 to amplify the second signal; the second auxiliary amplification element 8 to amplify the second signal amplified by the first auxiliary amplification element 7; the combination circuit 9 to combine the first signal amplified by the second main amplification element 6 and the second signal amplified by the second auxiliary amplification element 8; and the first phase adjustment circuit 13 connected between the first auxiliary amplification element 7 and the second auxiliary amplification element 8. The Doherty amplifier is then configured in such a way that the first phase adjustment circuit 13 adjusts either the phase of a return signal going to the first auxiliary amplification element 7 as a result of passage of the first signal amplified by the second main amplification element 6 through the second auxiliary amplification element 8 as the return signal, or the phase of the return signal going to the second auxiliary amplification element 8 as a result of reflection of the return signal by the first auxiliary amplification element 7, at the time of the backoff operation of the second auxiliary amplification element 8, in such a way that the sum of the phase of the return signal going to the first auxiliary amplification element 7 and the phase of the return signal going to the second auxiliary amplification element 8 is not equal to 0 degrees in the operating frequency band of the first signal. Therefore, the Doherty amplifier can prevent an oscillation phenomenon occurring between the first auxiliary amplification element 7 and the second auxiliary amplification element 8.

### Embodiment 2.

In Embodiment 2, a Doherty amplifier including a main amplification element 20 that amplifies a signal to be amplified and outputs the amplified signal to a signal splitter circuit 2 will be explained.

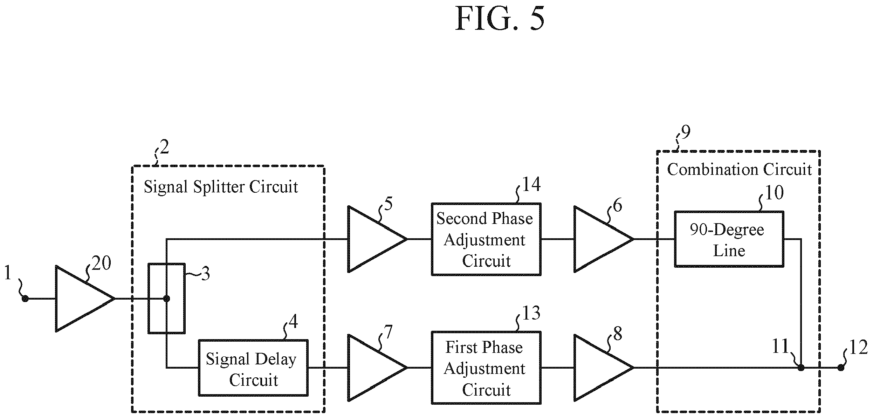

Fig. 5 is a schematic diagram showing the Doherty amplifier according to Embodiment 2. In Fig. 5, because the same reference signs as those shown in Fig. 1 denote the same components or like components, an explanation of the components will be omitted.

The main amplification element 20 is implemented by, for example, either an FET or an amplification circuit including an FET and an impedance conversion circuit.

The main amplification element 20 is a carrier amplifier that operates in AB class, and amplifies a signal to be amplified and outputs the amplified signal to a signal splitter circuit 2.

In Embodiment 2, the Doherty amplifier shown in Fig. 5 is configured in such a way as to include the main amplification element 20 that amplifies the signal to be amplified and outputs the amplified signal to the signal splitter circuit 2. Therefore, the Doherty amplifier shown in Fig. 5 can prevent an oscillation phenomenon occurring between a first auxiliary amplification element 7 and a second auxiliary amplification element 8, like the Doherty amplifier shown in Fig. 1. Further, the Doherty amplifier shown in Fig. 5 can increase the power of a composite signal to greater than that in the Doherty amplifier shown in Fig. 1.

In the Doherty amplifier shown in Fig. 5, the single main amplification element 20 is provided in a stage preceding the signal splitter circuit 2. However, this is only an example, and multiple main amplification elements 20 may be connected in series in a stage preceding the signal splitter circuit 2.

### Embodiment 3.

In Embodiment 3, a Doherty amplifier including a first signal generator 21 and a second signal generator 22 will be explained.

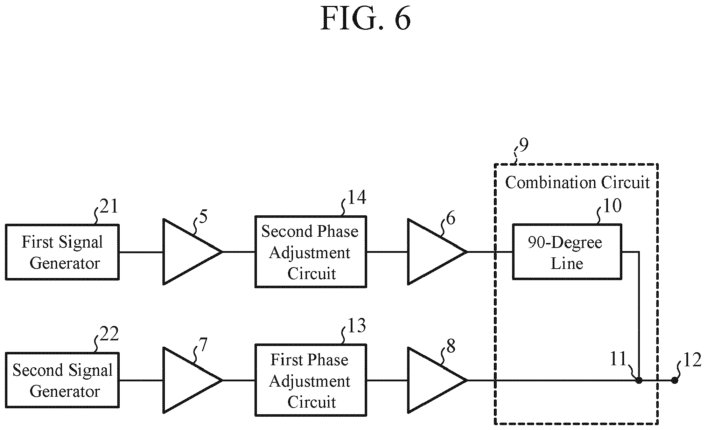

Fig. 6 is a schematic diagram showing the Doherty amplifier according to Embodiment 3. In Fig. 6, because the same reference signs as those shown in Fig. 1 denote the same components or like components, an explanation of the components will be omitted.

The first signal generator 21 generates a first signal, and can change each of the following quantities: the frequency and amplitude of the first signal. Further, the first signal generator 21 can synchronize the phase of the first signal with a reference phase.

The first signal generator 21 outputs the first signal whose phase is synchronized with the reference phase to a first main amplification element 5.

The second signal generator 22 generates a second signal, and can change each of the following quantities: the frequency and amplitude of the second signal.

The second signal generator 22 outputs the second signal whose phase lags 90 degrees behind the phase of the first signal outputted from the first signal generator 21 to a first auxiliary amplification element 7.

In the Doherty amplifier shown in Fig. 6, it is assumed that the first signal outputted from the first signal generator 21 and the second signal outputted from the second signal generator 22 have the same amplitude. However, this is only an example, and the first signal outputted from the first signal generator 21 and the second signal outputted from the second signal generator 22 may have different amplitudes.

The Doherty amplifier shown in Fig. 6 includes the first signal generator 21 and the second signal generator 22 instead of the signal splitter circuit 2 shown in Fig. 1. The first signal outputted from the first signal generator 21 to the first main amplification element 5 is the same as the first signal outputted from the signal splitter circuit 2 to the first main amplification element 5. Further, the second signal outputted from the second signal generator 22 to the first auxiliary amplification element 7 is the same as the second signal outputted from the signal splitter circuit 2 to the first auxiliary amplification element 7.

Therefore, the Doherty amplifier shown in Fig. 6 can prevent an oscillation phenomenon occurring between the first auxiliary amplification element 7 and a second auxiliary amplification element 8, like the Doherty amplifier shown in Fig. 1.

### INDUSTRIAL APPLICABILITY

The present disclosure is suitable for Doherty amplifiers.

### REFERENCE SIGNS LIST

1 input terminal, 2 signal splitter circuit, 3 T-branch circuit, 4 signal delay circuit, 5 first main amplification element, 6 second main amplification element, 7 first auxiliary amplification element, 8 second auxiliary amplification element, 9 combination circuit, 10 90-degree line, 11 signal combination point, 12 output terminal, 13 first phase adjustment circuit, 13a coil, 13b, 13c capacitor, 13d transmission line, 14 second phase adjustment circuit, 20 main amplification element, 21 first signal generator, and 22 second signal generator.

## Claims

1. A Doherty amplifier comprising:
a first main amplification element (5) to amplify a first signal;
a second main amplification element (6) to amplify the first signal amplified by the first main amplification element (5);
a first auxiliary amplification element (7) to amplify a second signal;
a second auxiliary amplification element (8) to amplify the second signal amplified by the first auxiliary amplification element (7);
a combination circuit (9) to combine the first signal amplified by the second main amplification element (6) and the second signal amplified by the second auxiliary amplification element (8); and
a phase adjustment circuit (13) connected between the first auxiliary amplification element (7) and the second auxiliary amplification element (8), is
wherein the phase adjustment circuit (13) configured to adjust either a phase of a return signal going to the first auxiliary amplification element (7) as a result of passage of the first signal amplified by the second main amplification element (6) through the second auxiliary amplification element (8) as the return signal, or a phase of the return signal going to the second auxiliary amplification element (8) as a result of reflection of the return signal by the first auxiliary amplification element (7), at a time of a backoff operation of the second auxiliary amplification element (8), in such a way that a sum of the phase of the return signal going to the first auxiliary amplification element (7) and the phase of the return signal going to the second auxiliary amplification element (8) is not equal to 0 degrees in an operating frequency band of the first signal,
wherein the phase adjustment circuit (13) has a characteristic impedance of the same value as an output impedance of the first auxiliary amplification element (7) at a time of a saturated operation or an input impedance of the second auxiliary amplification element (8) at a time of the saturated operation, and
wherein the time of the saturated operation is an operation when an output power of the first auxiliary amplification element (7) is the same as an output power of the first main amplification element (5) or an operation when an output power of the second auxiliary amplification element (8) is the same as an output power of the second main amplification element (6).

2. The Doherty amplifier according to claim 1, wherein the Doherty amplifier comprises a signal splitter circuit (2) to split a signal into two signals, output one of the signals after split, as the first signal, to the first main amplification element (5), delay a phase of the other one of the signals after split by 90 degrees, and output the other signal whose phase is delayed by 90 degrees, as the second signal, to the first auxiliary amplification element (7).

3. The Doherty amplifier according to claim 2, wherein the Doherty amplifier comprises a main amplification element (20) to amplify a signal to be amplified and output the amplified signal to the signal splitter circuit (2).

4. The Doherty amplifier according to claim 1, wherein the Doherty amplifier comprises a first signal generator (21) to output the first signal to the first main amplification element (5), and a second signal generator (22) to output the second signal whose phase lags 90 degrees behind a phase of the first signal outputted from the first signal generator (21) to the first auxiliary amplification element (7).

## Patentansprüche

1. Doherty-Verstärker, umfassend:
ein erstes Hauptverstärkungselement (5) zum Verstärken eines ersten Signals;
ein zweites Hauptverstärkungselement (6) zum Verstärken des ersten Signals, das durch das erste Hauptverstärkungselement (5) verstärkt wurde;
ein erstes Hilfsverstärkungselement (7) zum Verstärken eines zweiten Signals;
ein zweites Hilfsverstärkungselement (8) zum Verstärken des zweiten Signals, das durch das erste Hilfsverstärkungselement (7) verstärkt wurde;
eine Kombinationsschaltung (9) zum Kombinieren des ersten Signals, das durch das zweite Hauptverstärkungselement (6) verstärkt wurde, und des zweiten Signals, das durch das zweite Hilfsverstärkungselement (8) verstärkt wurde; und
eine Phasenanpassungsschaltung (13), die zwischen dem ersten Hilfsverstärkungselement (7) und dem zweiten Hilfsverstärkungselement (8) verbunden ist,
wobei die Phasenanpassungsschaltung (13) eingerichtet ist, entweder eine Phase eines zum ersten Hilfsverstärkungselement (7) gehenden Rücklaufsignals als Ergebnis des Durchgangs des durch das zweite Hauptverstärkungselement (6) verstärkten ersten Signals durch das zweite Hilfsverstärkungselement (8) als das Rücklaufsignal oder eine Phase des zum zweiten Hilfsverstärkungselement (8) gehenden Rücklaufsignals als Ergebnis einer Reflexion des Rücklaufsignals durch das erste Hilfsverstärkungselement (7) anzupassen, zu einem Zeitpunkt eines Backoff-Betriebs des zweiten Hilfsverstärkungselements (8), so dass eine Summe der Phase des Rücklaufsignals, das zum ersten Hilfsverstärkungselement (7) geht, und der Phase des Rücklaufsignals, das zum zweiten Hilfsverstärkungselement (8) geht, in einem Betriebsfrequenzband des ersten Signals nicht gleich 0 Grad ist,
wobei die Phasenanpassungsschaltung (13) eine charakteristische Impedanz mit dem gleichen Wert wie eine Ausgangsimpedanz des ersten Hilfsverstärkungselements (7) zum Zeitpunkt eines gesättigten Betriebs oder eine Eingangsimpedanz des zweiten Hilfsverstärkungselements (8) zum Zeitpunkt des gesättigten Betriebs aufweist, und
wobei der Zeitpunkt des gesättigten Betriebs ein Betrieb ist, wenn eine Ausgangsleistung des ersten Hilfsverstärkungselements (7) gleich einer Ausgangsleistung des ersten Hauptverstärkungselements (5) ist, oder ein Betrieb, wenn eine Ausgangsleistung des zweiten Hilfsverstärkungselements (8) gleich einer Ausgangsleistung des zweiten Hauptverstärkungselements (6) ist.

2. Doherty-Verstärker nach Anspruch 1, wobei der Doherty-Verstärker eine Signalteilerschaltung (2) umfasst, um ein Signal in zwei Signale aufzuteilen, eines der Signale nach der Teilung als das erste Signal an das erste Hauptverstärkungselement (5) auszugeben, eine Phase des anderen der Signale nach der Aufteilung um 90 Grad zu verzögern und das andere Signal, dessen Phase um 90 Grad verzögert ist, als das zweite Signal an das erste Hilfsverstärkungselement (7) auszugeben.

3. Doherty-Verstärker nach Anspruch 2, wobei der Doherty-Verstärker ein Hauptverstärkungselement (20) zum Verstärken eines zu verstärkenden Signals und zum Ausgeben des verstärkten Signals an die Signalteilerschaltung (2) umfasst.

4. Doherty-Verstärker nach Anspruch 1, wobei der Doherty-Verstärker einen ersten Signalgenerator (21) zum Ausgeben des ersten Signals an das erste Hauptverstärkungselement (5) und einen zweiten Signalgenerator (22) zum Ausgeben des zweiten Signals, dessen Phase um 90 Grad hinter einer Phase des vom ersten Signalgenerator (21) ausgegebenen ersten Signals zurückbleibt, an das erste Hilfsverstärkungselement (7) umfasst.

## Revendications

1. Amplificateur Doherty, comprenant :
un premier élément d'amplification principal (5) pour amplifier un premier signal ;
un deuxième élément d'amplification principal (6) pour amplifier le premier signal amplifié par le premier élément d'amplification principal (5) ;
un premier élément d'amplification auxiliaire (7) pour amplifier un deuxième signal ;
un deuxième élément d'amplification auxiliaire (8) pour amplifier le deuxième signal amplifié par le premier élément d'amplification auxiliaire (7) ;
un circuit de combinaison (9) pour combiner le premier signal amplifié par le deuxième élément d'amplification principal (6) et le deuxième signal amplifié par le deuxième élément d'amplification auxiliaire (8) ; et
un circuit d'ajustement de phase (13) connecté entre le premier élément d'amplification auxiliaire (7) et le deuxième élément d'amplification auxiliaire (8),
dans lequel le circuit d'ajustement de phase (13) est configuré pour ajuster soit une phase d'un signal de retour allant au premier élément d'amplification auxiliaire (7) suite au passage du premier signal amplifié par le deuxième élément d'amplification principal (6) à travers le deuxième élément d'amplification auxiliaire (8) en tant que signal de retour, soit une phase du signal de retour allant au deuxième élément d'amplification auxiliaire (8) suite à la réflexion du signal de retour par le premier élément d'amplification auxiliaire (7), au moment d'un fonctionnement de recul du deuxième élément d'amplification auxiliaire (8), de telle sorte qu'une somme de la phase du signal de retour allant au premier élément d'amplification auxiliaire (7) et de la phase du signal de retour allant au deuxième élément d'amplification auxiliaire (8) ne soit pas égale à 0 degré dans une bande de fréquence de fonctionnement du premier signal,
dans lequel le circuit d'ajustement de phase (13) a une impédance caractéristique de même valeur qu'une impédance de sortie du premier élément d'amplification auxiliaire (7) au moment d'un fonctionnement saturé ou qu'une impédance d'entrée du deuxième élément d'amplification auxiliaire (8) au moment du fonctionnement saturé, et
dans lequel le moment du fonctionnement saturé est un fonctionnement où une puissance de sortie du premier élément d'amplification auxiliaire (7) est identique à une puissance de sortie du premier élément d'amplification principal (5) ou un fonctionnement où une puissance de sortie du deuxième élément d'amplification auxiliaire (8) est identique à une puissance de sortie du deuxième élément d'amplification principal (6).

2. Amplificateur Doherty selon la revendication 1, dans lequel l'amplificateur Doherty comprend un circuit séparateur de signaux (2) pour séparer un signal en deux signaux, délivrer l'un des signaux après séparation, en tant que premier signal, au premier élément d'amplification principal (5), retarder de 90 degrés la phase de l'autre des signaux après séparation, et délivrer l'autre signal dont la phase est retardée de 90 degrés, en tant que deuxième signal, au premier élément d'amplification auxiliaire (7).

3. Amplificateur Doherty selon la revendication 2, dans lequel l'amplificateur Doherty comprend un élément d'amplification principal (20) pour amplifier un signal à amplifier et délivrer le signal amplifié au circuit séparateur de signaux (2).

4. Amplificateur Doherty selon la revendication 1, dans lequel l'amplificateur Doherty comprend un premier générateur de signal (21) pour délivrer le premier signal au premier élément d'amplification principal (5), et un deuxième générateur de signal (22) pour délivrer le deuxième signal dont la phase est décalée de 90 degrés par rapport à la phase du premier signal délivré par le premier générateur de signal (21) au premier élément d'amplification auxiliaire (7).
